# EUROPEAN PATENT APPLICATION

(11) **EP 3 929 252 A1**
(43) Date of publication of application: **29.12.2021**
(21) Application number: 20758811.2
(22) Date of filing: 20.02.2020
(51) Int. Cl.: C08L 101/00, G03F 7/004, G02B 5/20, G09F 9/30, H01L 27/32, C08K 3/04, H05B 33/12, H01L 51/50

(54) **RESIN COMPOSITION, CURED PRODUCT, BLACK MATRIX, COLOR FILTER, LIQUID CRYSTAL DISPLAY DEVICE, ORGANIC ELECTROLUMINESCENT DISPLAY DEVICE, AND METHOD FOR PRODUCING RESIN COMPOSITION**

(30) Priority: 20.02.2019 JP 2019028714
(71) Applicant: Sekisui Chemical Co., Ltd., Osaka-shi, Osaka 530-0047 (JP)
(72) Inventor: SUN, Ren-de, Mishima-gun, Osaka 618-0021 (JP); ISHII, Masahiro, Mishima-gun, Osaka 618-0021 (JP); FUKUI, Hiroji, Mishima-gun, Osaka 618-0021 (JP); NAKASUGA, Akira, Mishima-gun, Osaka 618-0021 (JP)
(74) Representative: Cabinet Beau de Loménie
(86) International application number: PCT/JP2020/006803
(87) International publication number: WO 2020/171168

(57) **Abstract**

The present invention provides a resin composition having a high optical density and capable of providing a high-quality color filter excellent in long-term stability and insulation properties. The present invention also provides a cured product of the resin composition, a black matrix, a color filter, a liquid crystal display device, an organic electroluminescent display device, and a method for producing the resin composition. Provided is a resin composition including: amorphous carbon-containing black particles; and a curable compound, the black particles having a specific gravity of 1.75 or lower and an oil absorption as set forth in JIS K 5101-13-1 of 30 ml/100 g or higher and 120 ml/100 g or lower.

## Description

### TECHNICAL FIELD

The present invention relates to a resin composition having a high optical density and capable of providing a high-quality color filter excellent in long-term stability and insulation properties. The present invention also relates to a cured product of the resin composition, a black matrix, a color filter, a liquid crystal display device, an organic electroluminescent display device, and a method for producing the resin composition.

### BACKGROUND ART

Image display devices such as liquid crystal color displays include color filters for displaying multicolor images. Such color filters need to include light shielding members called black matrix for preventing color mixing between color resists or light leakage during black display.

Thin metal films such as chromium films have been used as black matrix materials. However, thin metal films disadvantageously have high optical reflectivity and impose a considerable burden on the environment. For this reason, resin compositions containing resins and black pigments such as titanium black or carbon black dispersed in the resins are commonly used as black matrix materials.

As such a resin composition, for example, Patent Literature 1 discloses a polymerizable composition containing a polymerizable compound, a binder polymer, a photopolymerization initiator, and a titanium black dispersion. Patent Literature 2 discloses a black photosensitive composition containing a polymerizable compound, a photopolymerization initiator, and carbon black.

### CITATION LIST

### - Patent Literature

Patent Literature 1: WO 2009/122789
Patent Literature 2: JP 2012-141605 A

### SUMMARY OF INVENTION

### - Technical Problem

Titanium black, however, is disadvantageous in terms of long-term stability. Titanium when used in a resin composition is likely to sediment during storage because of its relatively high specific gravity of 3 or higher. Moreover, since titanium black is prepared by nitridization of part of a wide-band-gap titanium oxide, it is often brownish and has poor blackness. Carbon black having high electroconductivity may allow the black matrix to conduct, causing display failures.

The present invention aims to provide a resin composition having a high optical density and capable of providing a high-quality color filter excellent in long-term stability and insulation properties. The present invention also aims to provide a cured product of the resin composition, a black matrix, a color filter, a liquid crystal display device, an organic electroluminescent display device, and a method for producing the resin composition.

### - Solution to problem

The present invention relates to a resin composition including amorphous carbon-containing black particles and a curable compound, the black particles having a specific gravity of 1.75 or lower and an oil absorption as set forth in JIS K 5101-13-1 of 30 ml/100 g or higher and 120 ml/100 g or lower.

The present invention is specifically described in the following.

As a result of intensive studies, the present inventors found out that combination of a curable compound and amorphous carbon-containing black particles having a specific gravity and an oil absorption each within a predetermined range enables formation of a black matrix excellent in storage stability, light shielding properties, and insulation properties, leading to production of a high-quality color filter. Thus, the present invention was completed.

### (Black particles)

The resin composition of the present invention contains black particles.

The black particles contain amorphous carbon.

The amorphous carbon-containing black particles can be obtained at low cost as they are more easily preparable than conventional carbon-based black particles. In addition, having higher sphericity and dispersibility compared to those of conventional carbon-based black particles, the black particles can be used as a high-performance black pigment.

The amorphous carbon constituting the black particles has an amorphous structure including both sp2 bonds and sp3 bonds and is formed of carbon. Preferably, the peak intensity ratio between G band and D band obtained by analysis of a Raman spectrum of the amorphous carbon is 5.0 or lower.

In analysis of the amorphous carbon by Raman spectroscopy, two peaks including G band (at around 1580 cm⁻¹) corresponding to the sp2 bonds and D band (at around 1360 cm⁻¹) corresponding to the sp3 bonds are clearly observed. In the case of a crystalline carbon material, one of the two bands is minimized. For example, in the case of monocrystalline diamond, G band at around 1580 cm⁻¹ is hardly observed. In the case of a high-purity graphite structure, D band at around 1360 cm⁻¹ hardly appears.

In the present invention, insulation properties of the formed black particles can be maintained high particularly by setting the peak intensity ratio between G band and D band (peak intensity of G band/peak intensity of D band) to 5.0 or lower.

When the peak intensity ratio is higher than 5.0, the particles suffer not only reduction in insulation properties but also an increase in specific gravity. As a result, the resin composition has lower storage stability.

The peak intensity ratio is preferably 0.5 or higher and more preferably 4.0 or lower.

The adjustment of the heating temperature during heat treatment or the selection of the amorphous carbon material, for example, can adjust the peak intensity ratio between G band and D band. Specifically, a higher heating temperature during heat treatment tends to increase the peak intensity of G band.

In analysis of the Raman spectrum of the amorphous carbon constituting the black particles, the upper limit of the half width of the G band peak is preferably 200 cm⁻¹, more preferably 180 cm⁻¹. The lower limit of the half width is not particularly limited and is preferably as small as possible.

The amorphous carbon constituting the black particles is preferably derived from carbon contained in an oxazine resin. The oxazine resin can be carbonized at low temperature, enabling cost reduction.

The oxazine resin is commonly classified as a phenolic resin. The oxazine resin herein is a thermosetting resin obtained by reacting a phenol, formaldehyde, and an amine. In the case where the phenol used is of a type further including an amino group on the phenol ring, such as para-aminophenol, addition of an amine is not needed in the reaction and carbonization tends to be more easily achieved. For easier carbonization, use of a naphthalene ring, instead of a benzene ring, works.

Examples of the oxazine resin include a benzoxazine resin and a naphthoxazine resin. Of these two, a naphthoxazine resin is suitable as it can be carbonized at the lower temperature. The following formulas each show part of the structure of an oxazine resin. The formula (1) shows the partial structure of a benzoxazine resin and the formula (2) shows the partial structure of a naphthoxazine resin.

As seen from the formulas, an oxazine resin refers to a resin having a six-membered ring added to a benzene ring or naphthalene ring. The six-membered ring contains an oxygen atom and a nitrogen atom, from which the name "oxazine" derives.

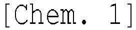

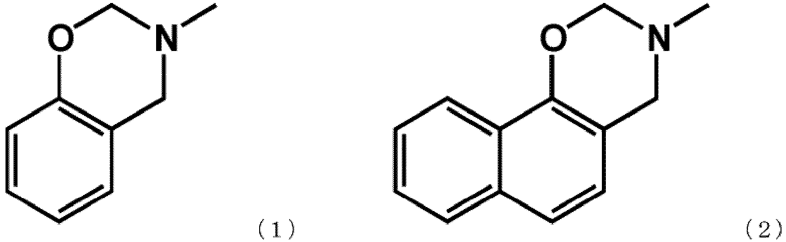

Use of the oxazine resin enables preparation of black particles at considerably lower temperature than that of other resins such as epoxy resins. Specifically, carbonization can be done at a temperature equal to or lower than 200°C. In particular, use of a naphthoxazine resin allows carbonization at still lower temperature.

Thus, carbonization at lower temperature with use of an oxazine resin enables formation of amorphous carbon-containing black particles in an appropriate solvent.

Though the reason why amorphous carbon-containing black particles can be produced by such a method is not clear, it is presumably because, when a naphthoxazine resin is used as the oxazine resin, naphthalene structures in the resin are locally connected by low-temperature heating to form a layered structure at a molecular level. The layered structure does not exhibit crystallinity because no high-temperature treatment has been performed thereon and therefore has no long-range periodic structure as graphite does.

Whether the obtained carbon has a graphite-like structure or has an amorphous structure can be confirmed by determining whether or not a peak is detected at a position where 2θ is 26.4° by an X-ray diffraction method described later.

Also, whether or not the obtained carbon is derived from carbon contained in the oxazine resin can be determined from an IR spectrum. Specifically, it can be confirmed by detecting both a peak (at 1334-1337 cm⁻¹) derived from out-of-plane symmetric bending vibration (wagging mode) of CH₂ in the oxazine ring and a peak (at 1232-1237 cm⁻¹) derived from asymmetric stretching vibration (the asymmetric stretching mode) of Ar (aromatic ring)-O-C in the FT-IR spectrum of the particles before heat treatment.

Examples of the raw material of the naphthoxazine resin include dihydroxynaphthalene that is a phenol, triazine, formaldehyde, and an amine. These materials are later described in detail.

The amorphous carbon is preferably obtained by heating the oxazine resin at a temperature of 50°C to 800°C. In the present invention, use of a naphthoxazine resin that can be carbonized at low temperature enables preparation of amorphous carbon at comparatively low temperature.

Preparation at such low temperature is advantageous in that the amorphous carbon can be produced at lower cost by a simpler process than conventional cases.

The heat treatment is more preferably performed at a temperature of 100°C to 600°C.

The black particles may contain element(s) other than carbon. Examples of the element(s) other than carbon include nitrogen, hydrogen, and oxygen. The amount of such element(s) is preferably 10 mol% or less based on the total of carbon and the element(s) other than carbon.

The amount of nitrogen is preferably 0.1 mol% or more and 5.0 mol% or less based on the total of carbon and the element(s) other than carbon.

The amounts can be measured by X-ray photoelectron spectroscopy.

The black particles may also contain a resin component.

The black particles preferably contain a nitrogen atom. The black particles containing a nitrogen atom have better physical properties than pure carbon particles.

The lower limit of the nitrogen content of the black particles is preferably 0.05% by weight, more preferably 0.1% by weight and the upper limit thereof is preferably 5.0% by weight, more preferably 3.0% by weight.

The black particles having a nitrogen content within the above range have still better physical properties.

The nitrogen content can be measured by X-ray photoelectron spectroscopy.

The black particles have a specific gravity of 1.75 or lower. The black particles having a specific gravity of 1.75 or lower have high dispersibility. The lower limit of the specific gravity is preferably 1.20 and the upper limit thereof is preferably 1.70.

The black particles have an oil absorption of 30 ml/100 g or more and 120 ml/100 g or less.

The black particles having an oil absorption of less than 30 ml/100 g have poor compatibility with a curable compound to be likely to aggregate. As a result, the optical density or the strength of a coating film lowers. Here, increasing the contents of the black particles is considered to be a method of increasing the optical density or the strength of a coating film. However, when the oil absorption is less than the lower limit, poor compatibility of the black particles with a curable compound does not allow well mixing of the black particles in a resin composition, which makes it difficult to add a large amount of black particles.

The black particles having an oil absorption of more than 120 ml/100 g adsorb a curable compound, lowering the flowability of the resulting resin composition. As a result, the dispersibility of the black particles in the resulting resin composition is lowered to lower the long-term stability and optical density.

The lower limit of the oil absorption is more preferably 40 ml/100 g and the upper limit thereof is more preferably 100 ml/100 g.

The oil absorption can be measured in conformity with JIS K 5101-13-1.

The oil absorption can be adjusted by appropriately adjusting the specific surface area, surface state, pore distribution, or pore size of the black particles. For example, the black particles having a larger specific surface area tend to have a greater oil absorption.

The lower limit of the average particle size of the black particles is 5 nm, more preferably 10 nm and the upper limit thereof is preferably 300 nm, more preferably 200 nm.

The black particles having an average particle size within the above range enable preparation of a resin composition having excellent properties.

The black particles may be a mixture of two or more types of particles different in average particle size.

The coefficient of variation (CV value) of the particle size of the black particles is preferably 20% or lower.

When the CV value of the particle size is 20% or lower, the black particles have better monodispersibility, which facilitates close packing of the black particles used as a black pigment. As a result, the effect of blocking visible light can be increased.

The upper limit of the CV value of the particle size is more preferably 15%. The lower limit is not particularly limited, and is preferably 0.5%.

The CV value (%) of the particle size is a value in percentage obtained by dividing the standard deviation by the average particle size, i.e., the numerical value obtained by the following equation. A smaller CV value means less variation in particle size. CV value (%) of particle size = (standard deviation of particle size/average particle size) × 100

The particle size and standard deviation can be measured with a FE-TEM.

The black particles preferably have an average sphericity of 90% or higher.

With such an average sphericity, the effect of the present invention is better obtained. The lower limit of the average sphericity is more preferably 95%.

The sphericity (breadth/length) can be determined by analyzing an electron micrograph taken with an FE-TEM or FE-SEM using an image analyzer. The average sphericity can be calculated by obtaining the average of sphericity values of, for example, arbitrary selected 100 particles in the electron micrograph.

The lower limit of the specific surface area of the black particles is preferably 1.0 m²/g, more preferably 5.0 m²/g and the upper limit thereof is preferably 1,000 m²/g, more preferably 800 m²/g.

The specific surface area can be measured by a gas adsorption method using nitrogen gas or the like.

The black particles preferably have a zeta potential (surface potential) of -70 to +80 mV.

The black particles having a zeta potential within the above range are excellent in particle size uniformity to have good dispersibility in a solvent.

The lower limit of the zeta potential is more preferably -60 mV and the upper limit thereof is more preferably 70 mV.

The zeta potential can be obtained using, for example, a micro-electrophoresis zeta potential analyzer. A solution containing black particles dispersed therein is poured into a measurement cell, and a voltage is applied thereto under microscopic observation. The potential at which particles stop moving (stand still) is the zeta potential.

The black particles preferably have an average total reflectance of 15% or lower as measured in a wavelength range of 400 to 800 nm.

The black particles having an average total reflectance within the above range absorb most of visible light to develop high blackness in the visible light region.

The upper limit of the average total reflectance is more preferably 10%.

It is preferred that no peak at which the total reflectance reaches the maximum value is detected in the measurement of the total reflectance of the black particles in a wavelength range of 400 to 800 nm.

The total reflectance can be measured, for example, using a spectrophotometer equipped with an integrating sphere.

The black particles preferably have a powder resistance of 5.0 × 10⁻¹ Ω·cm or higher at a load of 16 kN.

The black particles having a powder resistance satisfying the preferable lower limit enable preparation of a highly insulating resin composition.

The lower limit of the powder resistance at a load of 16 kN is more preferably 1.0 × 10° Ω·cm, still more preferably 1.0 × 10¹ Ω·cm.

In analysis of the black particles by time-of-flight secondary ion mass spectrometry (TOF-SIMS), at least one of a mass spectrum derived from a benzene ring or a mass spectrum derived from a naphthalene ring is preferably detected.

Detection of such a mass spectrum derived from a benzene ring or naphthalene ring confirms that the amorphous carbon is derived from carbon contained in an oxazine resin. Also, such black particles exhibit high denseness.

Herein, the mass spectrum derived from a benzene ring refers to a mass spectrum at around 77.12 and the mass spectrum derived from a naphthalene ring refers to a mass spectrum at around 127.27.

The analysis can be performed using, for example, a TOF-SIMS apparatus (available from IONTOF GmbH).

In the present invention, in analysis of the black particles by an X-ray diffraction method, no peak is preferably detected at a position where 2θ is 26.4°.

The peak at a position where 2θ is 26.4° is the crystalline peak of graphite. Detection of no peak at this position confirms that carbon constituting the black particles has an amorphous structure.

The analysis can be performed using, for example, an X-ray diffractometer (SmartLab Multipurpose, available from Rigaku Corporation).

The lower limit of the amount of the black particles in the resin composition of the present invention is preferably 10% by weight, more preferably 20% by weight, and the upper limit thereof is preferably 80% by weight, more preferably 60% by weight.

The black particles can be produced, for example, by a method including reacting a mixed solution containing triazine, dihydroxynaphthalene, and a solvent or a method including reacting a mixed solution containing formaldehyde, an aliphatic amine, dihydroxynaphthalene, and a solvent. Also, amorphous carbon-containing black particles can be produced by carbonizing resin particles through firing.

In the method including reacting a mixed solution containing triazine, dihydroxynaphthalene, and a solvent, a mixed solution containing a triazine derivative, dihydroxynaphthalene, and a solvent is first prepared. In the method including reacting a mixed solution containing formaldehyde, an aliphatic amine, dihydroxynaphthalene, and a solvent, a mixed solution containing formaldehyde, an aliphatic amine, dihydroxynaphthalene, and a solvent is first prepared.

Since the formaldehyde is unstable, formalin that is a formaldehyde solution is preferably used. Formalin normally contains a small amount of methanol as a stabilizer, in addition to formaldehyde and water. The formaldehyde used in the present invention may be formalin whose formaldehyde content is clear.

Paraformaldehyde that is a polymerization product of formaldehyde is also usable as a raw material but is poor in reactivity. Accordingly, formalin mentioned above is preferably used.

The aliphatic amine is represented by the formula R-NH₂ wherein R preferably represents an alkyl group containing 5 or less carbon atoms. Examples of the alkyl group containing 5 or less carbon atoms include, but not limited to, methyl, ethyl, n-propyl, isopropyl, cyclopropyl, n-butyl, isobutyl, s-butyl, t-butyl, cyclobutyl, cyclopropylmethyl, n-pentyl, cyclopentyl, cyclopropylethyl, and cyclobutylmethyl groups.

Since the molecular weight is preferably smaller, the substituent R is preferably a methyl group, an ethyl group, a propyl group or the like. Specifically, a compound called methylamine, ethylamine, propylamine or the like can be preferably used. Most preferred is methylamine having a smallest molecular weight among these.

The triazine derivative preferably has a structure represented by the following formula (3).

In the formula (3), R¹, R², and R³ each independently represent an aliphatic alkyl group or an aromatic organic group.

The aliphatic alkyl group preferably contains 1 to 20 carbon atoms.

In particular, for achieving a high carbonization rate and obtaining amorphous carbon-containing black particles excellent in denseness, more preferably used is 1,3,5-trimethyl hexahydro-1,3,5-triazine represented by the formula (3) wherein R¹, R², and R³ each represent a methyl group. The carbonization rate herein refers to a percentage of residues after firing.

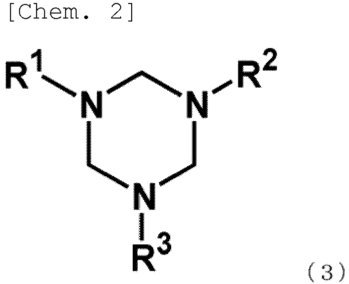

The dihydroxynaphthalene has many isomers. Examples thereof include 1,3-dihydroxynaphthalene, 1,5-dihydroxynaphthalene, 1,6-dihydroxynaphthalene, 1,7-dihydroxynaphthalene, 2,3-dihydroxynaphthalene, 2,6-dihydroxynaphthalene, and 2,7-dihydroxynaphthalene.

For higher reactivity, preferred among these are 1,5-dihydroxynaphthalene and 2,6-dihydroxynaphthalene. Still more preferred is 1,5-dihydroxynaphthalene having highest reactivity.

In the method of adding formaldehyde and an aliphatic amine without adding the triazine derivative, the ratio of dihydroxynaphthalene, an aliphatic amine, and formaldehyde in the mixed solution is most preferably 1 mol of an aliphatic amine and 2 mol of formaldehyde relative to 1 mol of dihydroxynaphthalene.

The optimum compounding ratio is not always the above ratio because the raw materials may be lost during the reaction due to volatilization or the like depending on the reaction conditions. Still, the compounding ratio is preferably 0.8 to 1.2 mol of an aliphatic amine and 1.6 to 2.4 mol of formaldehyde relative to 1 mol of dihydroxynaphthalene.

The aliphatic amine in an amount of 0.8 mol or more enables sufficient formation of an oxazine ring, suitably promoting polymerization. The aliphatic amine in an amount of 1.2 mol or less prevents excessive consumption of formaldehyde needed for the reaction, allowing smooth progress of the reaction. Thus, a desired naphthooxazine can be obtained. Similarly, formaldehyde in an amount of 1.6 mol or more enables sufficient formation of an oxazine ring, suitably promoting polymerization. Also, formaldehyde in an amount of 2.4 mol or less favorably reduces occurrence of side reactions.

The mixed solution contains a solvent for dissolving and reacting the above two or three raw materials.

Examples of the solvent include alcohols such as methanol, ethanol, and isopropanol, ketones such as acetone and methyl ethyl ketone, tetrahydrofuran, dioxane, chloroform, ethyl acetate, dimethylformamide, and dimethyl sulfoxide.

The solvent may be a single component solvent or a solvent mixture containing two or more solvents. The solvent used preferably has a solubility parameter (SP value) of 9.0 or higher.

Examples of the solvent having a SP value of 9.0 or higher include ethanol (12.7), methanol (14.7), isopropanol (11.5), 1-butanol (11.4), 1,3-butanediol (11.2), 1,4-butanediol (12.1), 2,3-butanediol (11.1), 2-methylpentane-1,3-diol (10.3), formamide (19.2), cresol (13.3), ethylene glycol (14.2), phenol (14.5), water (23.4), N,N-dimethylformamide (DMF, 12.3), dimethyl sulfoxide (DMSO, 13.0), methyl ethyl ketone (9.3), dioxane (10.3), ethyl acetate (9.0), chloroform (9.4), and acetone (10.0).

The solvent having a SP value of 9.0 or higher more preferably has a SP value of 9.0 to 15.0. In the case where the solvent used is a single component solvent, it preferably has a boiling point of 50°C to 300°C. The mixed solution more preferably contains a solvent having a boiling point of 50°C to 250°C and a SP value of 9.0 or higher.

In the case where the solvent is a solvent mixture containing two or more solvents, the solvent mixture preferably contains a solvent having a boiling point of 100°C or higher. Such a solvent mixture enables production of black particles having a high average sphericity.

The amount of the solvent in the mixed solution is, though not particularly limited, normally preferably 300 to 200,000 parts by mass based on 100 parts by mass of the raw materials (solute) including dihydroxynaphthalene, a triazine derivative, an aliphatic amine, and formaldehyde (corresponding to 1.0 to 0.001 M of the mol concentration of the solute). The mixed solution containing 300 parts by mass or more of the solvent better dissolves the solute, while the mixed solution containing the solvent in an amount of 200,000 parts by mass or less has an appropriate concentration of the solvent to facilitate the progress of the reaction.

The method for producing the black particles includes reacting the mixed solution. In the method, an oxazine resin such as a naphthoxazine resin is formed along with the progress of the reaction, followed by production of amorphous carbon-containing black particles.

For example, in the method including reacting the mixed solution containing dihydroxynaphthalene, a triazine derivative, an aliphatic amine, and formaldehyde, continuous warming makes a formed oxazine ring open, and polymerization increases the molecular weight to prepare a so-called naphthoxazine resin.

For uniform production of the black particles, the oxazine resin particles are preferably dispersed during the reaction. The dispersion method may be a known method such as stirring, ultrasonic dispersion, or rotation. For obtaining a better dispersion state, an appropriate dispersant may be added.

The step of reacting the mixed solution may be performed in one step or in two steps.

The two-step method preferably includes reacting the mixed solution to form oxazine resin particles and carbonizing the formed oxazine resin particles by heat treatment at a predetermined temperature.

In the step of forming the oxazine resin particles, the reaction gradually progresses even at room temperature. For efficient progress, the reaction is preferably carried out at a temperature of 50°C to 350°C. The reaction time can be adjusted according to the temperature, and is normally preferably 30 minutes to 20 hours. As a result of the reaction under the above conditions, spherical oxazine resin particles can be obtained. The oxazine resin particles obtained in this step is green, brown, or black depending on the reaction conditions.

The particle size of the oxazine resin particles can be adjusted by changing the parameters including concentration of the solution, reaction temperature, mole ratio of raw materials, and stirring conditions.

In the case where the reaction is carried out at a temperature not lower than the boiling point of the solvent, the reaction is preferably carried out in a pressurized container.

In the step of carbonizing the formed oxazine resin particles by heat treatment at a predetermined temperature, the heating temperature is preferably 150°C to 800°C. The heat treatment time is not particularly limited and is preferably 1 to 30 hours from the standpoint of the completeness of carbonization and an economic standpoint. In this step, the naphthoxazine resin is carbonized to form amorphous carbon-containing black particles. For carbonization of a conventional resin, treatment at a higher temperature is needed. In the present invention, amorphous carbon can be obtained even at such a low temperature as 150°C because an oxazine resin that can be carbonized at low temperature is used.

The heat treatment may be performed in the air, in a vacuum, or in an inert gas such as nitrogen or argon gas. In the case where the heat treatment is performed at not lower than 200°C, an inert gas atmosphere is preferred.

The method may include a drying step of removing the solvent by drying such as hot-air drying or vacuum drying, prior to the carbonization by heat treatment. The heat drying method is not particularly limited.

### (Curable compound)

The resin composition of the present invention contains a curable compound.

The curable compound may be a heat-curable compound or a photocurable compound. Preferred is a photocurable compound.

Examples of the curable compound include styrene compounds, phenoxy compounds, oxetane compounds, epoxy compounds, episulfide compounds, (meth)acrylic compounds, unsaturated polyester compounds, polyurethane compounds, silicone compounds, polyimide compounds, and allyl alcohol derivatives. One curable compound may be used or two or more curable compounds may be used in combination.

The curable compound may be a compound having a molecular weight of less than 10,000 or a compound having a molecular weight or 10,000 or more. Alternatively, such two compounds may be used in combination.

Examples of the styrene compounds include homopolymers of styrenic monomers and copolymers of styrenic monomers and acrylic monomers.

Examples of the styrenic monomers include styrene, o-styrene, m-styrene, p-styrene, p-methoxystyrene, p-phenylstyrene, p-chlorostyrene, p-ethylstyrene, p-n-butylstyrene, p-tert-butylstyrene, p-n-hexylstyrene, p-n-octylstyrene, p-n-nonylstyrene, p-n-decylstyrene, p-n-dodecylstyrene, 2,4-dimethylstyrene, and 3,4-dichlorostyrene.

Examples of the phenoxy compounds include resins obtained by reacting epihalohydrin and divalent phenol compounds and resins obtained by reacting divalent epoxy compounds and divalent phenol compounds.

Specific examples thereof include compounds having a bisphenol A type skeleton, a bisphenol F type skeleton, a bisphenol A/F mixed type skeleton, a naphthalene skeleton, a fluorene skeleton, a biphenyl skeleton, an anthracene skeleton, a pyrene skeleton, a xanthene skeleton, an adamantane skeleton, or a dicyclopentadiene skeleton.

Examples of the oxetane compounds include allyloxyoxetane, phenoxymethyloxetane, 3-ethyl-3-hydroxymethyloxetane, 3-ethyl-3-(phenoxymethyl)oxetane, 3-ethyl-3-((2-ethylhexyloxy)methyl)oxetane, 3-ethyl-3-((3-(triethoxysilyl)propoxy)methyl)oxetane, 3-ethyl-3-(((3-ethyloxetan-3-yl)methoxy)methyl)oxetane, oxetanyl silsesquioxane, phenol novolac oxetane, and 1,4-bis(((3-ethyl-3-oxetanyl)methoxy)methyl)benzene.

Examples of the epoxy compounds include bisphenol A type epoxy resins, bisphenol E type epoxy resins, bisphenol F type epoxy resins, bisphenol S type epoxy resins, bisphenol O type epoxy resins, 2,2'-diallyl bisphenol A type epoxy resins, cycloaliphatic epoxy resins, hydrogenated bisphenol type epoxy resins, propylene oxide-added bisphenol A type epoxy resins, resorcinol type epoxy resins, biphenyl type epoxy resins, sulfide type epoxy resins, diphenyl ether type epoxy resins, dicyclopentadiene type epoxy resins, naphthalene type epoxy resin, phenol novolac type epoxy resins, ortho cresol novolac type epoxy resins, dicyclopentadiene novolac type epoxy resins, biphenyl novolac type epoxy resins, naphthalenephenol novolac type epoxy resins, glycidylamine type epoxy resins, alkylpolyol type epoxy resins, rubber-modified epoxy resins, and glycidyl ester compounds.

Examples of the episulfide compounds include episulfide compounds obtainable by converting epoxy groups in epoxy compounds to episulfide groups.

Examples of the (meth)acrylic compounds include ester compounds obtainable by reacting (meth)acrylic acid with hydroxy group-containing compounds, epoxy (meth)acrylates obtainable by reacting (meth)acrylic acid with epoxy compounds, and urethane (meth)acrylates obtainable by reacting isocyanate compounds with hydroxy group-containing (meth)acrylic acid derivatives.

Examples of the ester compounds include monofunctional ester compounds including imide acrylates such as phthalimide acrylates (e.g., N-acryloyloxyethyl hexahydrophthalimide), methyl (meth)acrylate, ethyl (meth)acrylate, propyl (meth)acrylate, n-butyl (meth)acrylate, isobutyl (meth)acrylate, t-butyl (meth)acrylate, n-octyl (meth)acrylate, isooctyl (meth)acrylate, 2-ethylhexyl (meth)acrylate, isononyl (meth)acrylate, isodecyl (meth)acrylate, lauryl (meth)acrylate, isomyristyl (meth)acrylate, stearyl (meth)acrylate, cyclohexyl (meth)acrylate, isobornyl (meth)acrylate, dicyclopentenyl (meth)acrylate, benzyl (meth)acrylate, 2-hydroxyethyl (meth)acrylate, 2-hydroxypropyl (meth)acrylate, 2-hydroxybutyl (meth)acrylate, 4-hydroxybutyl (meth)acrylate, 2-methoxyethyl (meth)acrylate, 2-ethoxyethyl (meth)acrylate, 2-butoxyethyl (meth)acrylate, methoxyethylene glycol (meth)acrylate, methoxypolyethylene glycol (meth)acrylate, ethyl carbitol (meth)acrylate, tetrahydrofurfuryl (meth)acrylate, 2-phenoxyethyl (meth)acrylate, phenoxydiethylene glycol (meth)acrylate, phenoxypolyethylene glycol (meth)acrylate, 2,2,2-trifluoroethyl (meth)acrylate, 2,2,3,3-tetrafluoropropyl (meth)acrylate, 1H,1H,5H-octafluoropentyl (meth)acrylate, dimethylaminoethyl (meth)acrylate, diethylaminoethyl (meth)acrylate, 2-(meth)acryloyloxyethyl succinate, 2-(meth)acryloyloxyethyl hexahydrophthalate, 2-(meth)acryloyloxyethyl 2-hydroxypropylphthalate, glycidyl(meth)acrylate, and 2-(meth)acryloyloxyethyl phosphate.

The examples also include bifunctional ester compounds including 1,3-butanediol di(meth)acrylate, 1,4-butanediol di(meth)acrylate, 1,6-hexanediol di(meth)acrylate, 1,9-nonanediol di(meth)acrylate, 1,10-decanediol di(meth)acrylate, 2-n-butyl-2-ethyl-1,3-propanediol di(meth)acrylate, ethylene glycol di(meth)acrylate, diethylene glycol di(meth)acrylate, tetraethylene glycol di(meth)acrylate, polyethylene glycol di(meth)acrylate, dipropylene glycol di(meth)acrylate, tripropylene glycol di(meth)acrylate, polypropylene glycol (meth)acrylate, ethylene oxide-added bisphenol A di(meth)acrylate, propylene oxide-added bisphenol A di(meth)acrylate, ethylene oxide-added bisphenol F di(meth)acrylate, dimethylol dicyclopentadienyl di(meth)acrylate, neopentyl glycol di(meth)acrylate, ethylene oxide-modified isocyanuric acid di(meth)acrylate, 2-hydroxy-3-(meth)acryloyloxypropyl (meth)acrylate, carbonate diol di(meth)acrylate, polyether diol di(meth)acrylate, polyester diol di(meth)acrylate, polycaprolactone diol di(meth)acrylate, and polybutadiene diol di(meth)acrylate.

The examples further include tri-or higher functional ester compounds including trimethyrolpropane tri(meth)acrylate, ethylene oxide-added trimethyrolpropane tri(meth)acrylate, propylene oxide-added trimethyrolpropane tri(meth)acrylate, caprolactone-modified trimethyrolpropane tri(meth)acrylate, pentaerythritol tri(meth)acrylate, ethylene oxide-added isocyanuric acid tri(meth)acrylate, glycerol tri(meth)acrylate, propylene oxide-added glycerol tri(meth)acrylate, tris(meth)acryloyloxyethyl phosphate, ditrimethylolpropane tetra(meth)acrylate, pentaerythritol tetra(meth)acrylate, dipentaerythritol penta(meth)acrylate, and dipentaerythritol hexa(meth)acrylate.

Examples of the epoxy (meth)acrylate include those obtainable by reacting epoxy compounds with (meth)acrylic acid in the presence of basic catalysts by common methods.

Examples of the allyl alcohol derivatives include diallyl compounds such as diallyl maleate, diallyl adipate, diallyl phthalate, glycerol 1,3-diallyl ether, trimethylolpropane diallyl ether, triallyl compounds such as triallyl cyanurate, triallyl isocyanurate, triallyl trimellitate, and pentaerythritol triallylether, and tetraallyl compounds such as tetraallyl pyromellitate.

The curable compound used is preferably a compound containing two or more ethylenic unsaturated bonds such as an allyl alcohol derivative or a (meth)acrylic compound. Examples of a group containing the ethylenic unsaturated bonds include vinyl, allyl, and (meth)acryloyl groups. For effective progress of the reaction and further reduction of foaming, peeling, or discoloration of the cured product, preferred is a (meth)acryloyl group. The photocurable compound preferably contains a (meth)acryloyl group.

The lower limit of the amount of the curable compound in the resin composition of the present invention is preferably 5% by weight, more preferably 10% by weight and the upper limit thereof is preferably 90% by weight, more preferably 85% by weight.

### (Curing agent)

The resin composition of the present invention may further contain a curing agent such as a heat curing agent or a photocuring agent.

A heat curing agent capable of curing the heat-curable compound can be used as the heat curing agent. Examples of the heat curing agent include amine curing agents, imidazole curing agents, phenol curing agents, and acid anhydride curing agents. One heat curing agent may be used or two or more heat curing agents may be used in combination.

Examples of the amine curing agents include dicyandiamide, diaminodiphenylmethane, and diaminodiphenylsulfone.

Examples of the imidazole curing agents include 2-undecylimidazole, 2-heptadecylimidazole, 2-methylimidazole, 2-ethyl-4-methylimidazole, 2-phenylimidazole, 2-phenyl-4-methylimidazole, 1-benzyl-2-methylimidazole, 1-benzyl-2-phenylimidazole, 1,2-dimethylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-methylimidazole isocyanuric acid adduct, 2-phenyl-4,5-dihydroxymethylimidazole, and 2-phenyl-4-methyl-5-dihydroxymethylimidazole.

Examples of the phenol curing agents include phenol novolac, o-cresol novolac, p-cresol novolac, t-butylphenol novolac, dicyclopentadiene cresol, polyparavinylphenol, bisphenol A type novolac, xylylene-modified novolac, decalin-modified novolac, poly(di-o-hydroxyphenyl)methane, poly(di-m-hydroxyphenyl)methane, and poly(di-p-hydroxyphenyl)methane.

Examples of the acid anhydride curing agents include acid anhydrides having aromatic skeletons, and hydrogenated products and modified products thereof. Specific examples thereof include styrene/maleic anhydride copolymer, benzophenone tetracarboxylic acid anhydride, pyromellitic acid anhydride, trimellitic acid anhydride, 4,4'-oxydiphthalic acid anhydride, phenylethynyl phthalic acid anhydride, glycerol bis(anhydrotrimellitate)monoacetate, ethylene glycol bis(anhydrotrimellitate), methyltetrahydrophthalic anhydride, methylhexahydrophthalic anhydride, and trialkyltetrahydrophthalic anhydride.

A photocuring agent capable of curing the photocurable compound by irradiation with light can be used as the photocuring agent.

Examples of the photocuring agent include acylphosphine oxide, halomethylated triazine, halomethylated oxadiazole, imidazole, benzoin, benzoin alkylether, anthraquinone, benzanthrone, benzophenone, acetophenone, thioxanthone, benzoic acid esters, acridine, phenazine, titanocene, α-aminoalkylphenone, oxime, and derivatives of these. Each of these may be used alone or in combination of two or more.

Examples of the benzophenone photocuring agent include methyl o-benzoylbenzoate and Michler's ketone. Exemplary commercial products of the benzophenone photocuring agent include EAB (available from Hodogaya Chemical Co., Ltd.).

Exemplary commercial products of the acylphosphine oxide photocuring agent include Lucirin TPO (available from BASF SE) and IRGACURE 819 (available from Ciba Specialty Chemicals).

Exemplary commercial products of the thioxanthone photocuring agent include isopropyl thioxanthone and diethyl thioxanthone.

Exemplary commercial products of the alkylphenone photocuring agent include DAROCUR 1173, DAROCUR 2959, IRGACURE 184, IRGACURE 907, IRGACURE 369, IRGACURE 379, IRGACURE 651 (all available from BASF SE), and ESACURE 1001M (available from Lamberti).

The lower limit of the amount of the curing agent in the resin composition of the present invention is preferably 0.1% by weight, more preferably 1% by weight and the upper limit thereof is preferably 10% by weight, more preferably 5% by weight.

The resin composition of the present invention may further contain a solvent.

Examples of the solvent include water and solvent mixtures containing hydrophilic solvents (e.g., ethyl alcohol, isopropyl alcohol) and water. Preferably, water alone is used as the solvent.

The amount of the solvent in the resin composition of the present invention is not particularly limited and appropriately determined in a manner that the resin composition has a viscosity appropriate for the employed application method or the like. The resin composition preferably contains the solvent such that the solid content concentration of the resin composition is 100 to 50% by weight, more preferably 98 to 65% by weight.

The resin composition of the present invention may contain a dispersant for better dispersibility of the black particles.

Examples of the dispersant include polyvinyl alcohols, polyvinyl pyrrolidones, acrylic resins such as acrylic acid-acrylic acid ester copolymers, styrene-acrylic resins such as styrene-acrylic acid copolymers, styrene-methacrylic acid copolymers, styrene-methacrylic acid-acrylic acid ester copolymers, styrene-α-methylstyrene-acrylic acid copolymers, and styrene-α-methylstyrene-acrylic acid-acrylic acid ester copolymers, styrene-maleic acid copolymers, styrene-maleic anhydride copolymers, vinyl naphthalene-acrylic acid copolymers, and salts of these.

The resin composition of the present invention may contain a silane coupling agent for better adhesion between the pattern formed by the resin composition and a substrate.

Examples of the silane coupling agent include 3-(meth)acryloyloxypropyl trimethoxysilane, 3-(meth)acryloyloxypropyl triethoxysilane, 3-(meth)acryloyloxypropyl methyldiethoxysilane, and 3-(meth)acryloyloxypropyl triethoxysilane.

The resin composition of the present invention may contain a reaction aid for reducing interference of the reaction. Use of the reaction aid can improve the effect rate upon exposure to light.

Examples of the usable reaction aid include amine reaction aids, phosphine reaction aids, and sulfonic acid reaction aids.

Examples of the amine reaction aids include n-butylamine, di-n-butylamine, triethylamine, triethylenetetramine, ethyl p-dimethylaminobenzoate, and isoamyl p-dimethylaminobenzoate.

Examples of the phosphine reaction aids include tri-n-butylphosphine.

Examples of the sulfonic acid reaction aids include s-benzyl-isothiuronium-p-toluene sulfinate.

The resin composition of the present invention preferably has an optical density per 1 µm in thickness of 0.6 or higher.

The resin composition having an optical density of 0.6 or higher can sufficiently increase the blackness to sufficiently suppress light leakage or light diffusion.

The optical density is more preferably 1.0 or higher.

The optical density can be measured, for example, with a transmission densitometer.

If needed, the resin composition of the present invention may contain known additives such as other coupling agents, heat polymerization inhibitors, defoamers, leveling agents, sensitizers, curing accelerators, photocrosslinking agents, dispersion aids, fillers, adhesion improvers, antioxidants, ultraviolet absorbers, or aggregation inhibitors, within a range that the aim of the present invention is not inhibited.

The resin composition of the present invention may be produced, for example, by mixing black particles, a curable compound, and other additives added according to need such as a curing agent or a solvent using a stirrer. For obtaining a uniform mixture, the mixture is preferably filtered after stirring.

The present invention also encompasses a method for producing a resin composition, including preparing a mixed solution containing formaldehyde, an aliphatic amine, and dihydroxynaphthalene or a mixed solution containing triazine and dihydroxynaphthalene; reacting the mixed solution to form oxazine resin particles; and carbonizing the oxazine resin particles by heat treatment to obtain amorphous carbon-containing black particles.

A cured product can be produced by curing the resin composition of the present invention.

The present invention also encompasses such a cured product.

The resin composition of the present invention can be suitably used as a material of a black matrix formed in a color filter. The present invention also encompasses a black matrix formed from the resin composition of the present invention. The present invention also encompasses a color filter including a substrate and the black matrix of the present invention.

An exemplary method for forming the black matrix of the present invention from the resin composition of the present invention is described below.

First, the resin composition of the present invention is applied to a substrate formed of glass, polyethylene terephthalate, an acrylic resin, polycarbonate, or the like using a contact-type coater such as a roll coater, a reverse coater, a gravure coater, a comma coater, or a bar coater, or a contactless coater such as a spin coater, a slit coater, or a curtain flow coater.

Next, the applied resin composition is dried by, for example, low-pressure drying at room temperature using a vacuum drier and subsequent drying at 80°C or higher and 120°C or lower, preferably 90°C or higher and 100°C or lower for 60 seconds or longer and 180 seconds or shorter using a hot plate or an oven. Thus, a coating film is formed.

The obtained coating film is partly exposed to active energy rays such as UV light or excimer laser light through a negative mask. Before irradiation with active energy rays, the obtained coating film and a negative mask are preferably irradiated with near infrared rays for positioning of them by near-IR alignment.

The energy dose for the irradiation varies according to the formulation of the resin composition of the present invention, and is preferably 100 to 2,000 mJ/cm².

The coating film after exposure is patterned in a desired pattern by development using an alkaline solution. The developing method using an alkaline solution may be, for example, an immersion method, a spraying method, and a paddle method. Examples of the alkaline solution used as a developing solution include aqueous solutions of sodium hydroxide, potassium hydroxide, sodium carbonate, ammonia, tetramethyl ammonium hydroxide, and quaternary ammonium salt.

In the case where a developing solution containing an alkaline solution is used, commonly, the excess of the developing solution is removed by washing (rinsing) with pure water after the development.

The pattern after the development is subjected to post baking at around 220°C to 250°C, preferably around 230°C to 240°C, if needed. At that time, the formed pattern is preferably entirely exposed before post baking.

As above, a black matrix having a predetermined pattern can be formed.

The above operation for forming the black matrix of the present invention is performed also for a photosensitive resin composition in which a red pigment is dispersed, a photosensitive resin composition in which a green pigment is dispersed, and a photosensitive resin composition in which a blue pigment is dispersed, thereby forming a pixel pattern for each color. Thus, the color filter of the present invention can be formed.

Conventionally known compositions may be used for the photosensitive resin composition in which a red pigment is dispersed, the photosensitive resin composition in which a green pigment is dispersed, and the photosensitive resin composition in which a blue pigment is dispersed.

The color filter of the present invention can be also produced by a method including discharging red, green, and blue inks from ink-jet nozzles into regions defined by the black matrix of the present invention and curing the discharged ink with heat or light.

The color filter of the present invention can be suitably used as a member of a display device such as a liquid crystal display device or an organic electroluminescent display device. The present invention also encompasses a liquid crystal display device and an organic electroluminescent display device each including the color filter of the present invention.

### - Advantageous Effects of Invention

The present invention can provide a resin composition having a high optical density and capable of providing a high-quality color filter excellent in long-term stability and insulation properties. The present invention can also provide a cured product of the resin composition, a black matrix, a color filter, a liquid crystal display device, an organic electroluminescent display device, and a method for producing the resin composition.

### DESCRIPTION OF EMBODIMENTS

Embodiments of the present invention are more specifically described with reference to, but not limited to, examples below.

### (Example 1)

In 1-butanol in an amount of 10 g were sequentially dissolved 1.0 g of 1,5-dihydroxynaphthalene (1,5-DHN, available from Tokyo Chemical Industry Co., Ltd.) and 0.8 g of 1,3,5-trimethylhexahydro-1,3,5-triazine (available from Tokyo Chemical Industry Co., Ltd.). Thus, a 1-butanol mixed solution was prepared.

Separately, 160 g of 1,4-dioxane and 10 g of ion exchange water were mixed to prepare an aqueous solution. The obtained aqueous solution was held at 40°C with stirring, and the 1-butanol mixed solution was dropwise added thereto over six hours, followed by stirring for three hours. Thus, a particle dispersion was prepared.

To the particle dispersion were further added 180 g of ion exchange water and 180 g of 1-butanol, followed by removal of the solvent for recovery of the particles.

The infrared absorption spectrum of the particles was measured by Fourier transform infrared spectroscopy (FT-IR, NICOLET 6700). As a result, a peak (at 1334-1337 cm⁻¹) derived from out-of-plane symmetric bending vibration (wagging mode) of CH₂ in an oxazine ring and a peak (at 1232-1237 cm⁻¹) derived from asymmetric stretching vibration (the asymmetric stretching mode) of -O-C in a naphthalene ring were simultaneously detected. This confirmed the presence of naphthoxazine in the particles.

The particles were subjected to heat treatment at 200°C for two hours in a vacuum atmosphere. Thus, amorphous carbon particles as black particles were obtained.

The average particle size of the obtained amorphous carbon particles was measured by analysis of an FE-SEM image of the particles using image analysis software (WINROOF, available from Mitani Corporation). Also, the standard deviation was calculated to calculate the coefficient of variation (CV value) of the particle size from the obtained numerical value. Moreover, the sphericity was determined from the ratio between the minimum particle size and the maximum particle size to calculate the average sphericity. The average particle size was 90 nm, the CV value of the particle size was 15%, and the sphericity was 0.99. The specific surface area of the particles measured by a BET adsorption method was 20 m²/g_{.}

The particles were analyzed using an X-ray diffractometer (SmartLab Multipurpose, available from Rigaku Corporation) under the conditions of X-ray wavelength: CuKα 1.54 A, measurement range: 2θ = 10° to 70°, scanning rate: 4°/min, and step size: 0.02°. As a result, no peak was detected at the position of θ = 26.4°.

The elemental composition of the amorphous carbon particles was determined by X-ray photoelectron spectroscopy (XPS) to detect nitrogen (N) in addition to carbon (C) and oxygen (O). The nitrogen content relative to the total of the three elements was 4.5 mol%.

The obtained particles were subjected to Raman measurement. The ratio between G band and D band was 0.8.

Whether the mass spectrum (around 77.12) derived from a benzene ring and the mass spectrum (around 127.27) derived from a naphthalene ring were present was determined by time-of-flight secondary ion mass spectrometry (TOF-SIMS) using a TOF.SIMS 5 (available from IONTOF GmbH). As a result, the mass spectrum derived from a benzene ring and the mass spectrum derived from a naphthalene ring were detected. The TOF-SIMS measurement was carried out under the following conditions. For minimizing contamination derived from a storage case or the air, a sample after production was stored in a clean case for storing silicon wafers.

### <Measurement condition>

Primary ion: 209Bi+1
Ion voltage: 25 kV
Ion current: 1 pA
Mass range: 1 to 300 mass
Analysis area: 500 × 500 µm
Charge prevention: electron irradiation neutralization Random raster scan

As a result of the measurement of the diffuse reflectance spectrum of the amorphous carbon particles using a spectrophotometer equipped with an integrating sphere (V-760, available from Jasco Corp.), the average total light reflectance in the visible light region (wavelength of 400 to 800 nm) was 12%. Moreover, in that region, no absorption peak was observed.

Compounds shown in Table 1 were used as curable compounds and blended at the ratio shown in Table 1.

In addition, IRGACURE 907 (available from BASF SE) was used as a curing agent. Materials shown in Table 2 were blended at the ratio shown in Table 2 at room temperature. Thus, a resin composition was prepared.

### (Example 2)

A particle dispersion was prepared as in Example 1, except that 0.8 g of 1,3,5-trimethylhexahydro-1,3,5-triazine was replaced with 0.968 g of methylamine having a concentration of 40% and 2.023 g of formaldehyde having a concentration of 37%.

As in Example 1, the presence of a naphthoxazine resin in the particles was confirmed.

Black particles were obtained as in Example 1, except that the obtained particles were subjected to heat treatment in a nitrogen atmosphere at 500°C for two hours.

According to the measurement as in Example 1, the black particles had an average particle size of 50 nm, a specific surface area of 400 m²/g, a specific gravity of 1.7, a nitrogen content of 1.5 mol%, and an average total reflectance in the visible light region (wavelength of 400 to 800 nm) of 3%. No peak was detected at a position of θ = 26.4°.

According to analysis of the obtained particles by Raman spectroscopy, the ratio between G band and D band was 2.1.

A resin composition was prepared as in Example 1, except that the obtained black particles were used.

### (Comparative Example 1)

A resin composition was prepared as in Example 1, except that the amorphous carbon particles were replaced with titanium black (available from Mitsubishi Materials Corporation, average particle size: 90 nm).

### (Comparative Example 2)

A resin composition was prepared as in Example 1, except that the amorphous carbon particles were replaced with carbon black (EC600JD, available from Lion Specialty Chemicals Co., Ltd., average particle size: 34 nm).

### (Comparative Example 3)

A resin composition was prepared as in Example 1, except that the amorphous carbon particles were replaced with graphite particles (average particle size: 8 µm).

### (Evaluation method)

### (1) Oil absorption

Oil absorption was determined in conformity with JIS K 5101-13-1. A sample in an amount of 1 g from the amorphous carbon particles obtained in Example 1 was placed in the center of a measuring plate (3-mm-thick soda glass plate). To the center of the sample was gradually dripped refined linseed oil in a burette drop by drop. Each dripping was followed by sufficient kneading of the whole with a spatula.

The dripping of refined linseed oil and kneading were repeated. After the particles and oil were kneaded into a hard putty bulk, the dripping of refined linseed oil and kneading were further repeated. The end point of the operation was set just before sudden softening of the kneaded bulk by dripping of another drop of refined linseed oil. The operation was adjusted to set the operation time from start to the end point to about 10 minutes.

The amount of the refined linseed oil dripped from the burette till the end point was read and converted to the amount of the dripped oil per 100 g of the sample. The converted value was taken as the oil absorption value.

The measurement of the oil absorption was performed in the same manner for the amorphous carbon particles obtained in Example 2, titanium black used in Comparative Example 1, carbon black used in Comparative Example 2, and graphite particles used in Comparative Example 3.

### (2) Specific gravity

The specific gravity of the amorphous carbon particles obtained in Example 1 was measured using a dry automatic pycnometer (Accupyc II134, available from Shimadzu Corporation) (sample amount: 0.2 g).

The measurement of the specific gravity was performed in the same manner for the amorphous carbon particles obtained in Example 2, titanium black used in Comparative Example 1, carbon black used in Comparative Example 2, and graphite particles used in Comparative Example 3.

### (3) Powder resistance

The volume resistivity of the amorphous carbon particles obtained in Example 1 was measured using a powder resistivity measurement system (available from Mitsubishi Chemical Analytech Co., Ltd.) to obtain powder resistance at a load of 16 kN.

The measurement of the powder resistance was performed in the same manner for the amorphous carbon particles obtained in Example 2, titanium black used in Comparative Example 1, carbon black used in Comparative Example 2, and graphite particles used in Comparative Example 3.

### (4) Optical density of coating film (OD value)

### (Formation of coating film)

The resin compositions obtained in Examples 1 and 2 and Comparative Examples 1 to 3 were each applied with a knife coater to a glass slide preliminarily subjected to silane coupling agent treatment, followed by curing treatment under irradiation of UV light at a wavelength of 365 nm at an intensity of 6,000 mJ/cm². Thus, a coating film was obtained.

### (Measurement of optical density)

The optical density (OD value) of the obtained coating film was measured with a transmission densitometer ("Model 301", available from X-Rite Inc.).

The resin composition of Comparative Example 2 had poor adhesion after curing, and powdery cured product fell off from the glass, failing to form a coating film. Accordingly, evaluation could not be performed.

The resin composition of Comparative Example 3 sedimented badly, failing to form an evaluable coating film. Accordingly, evaluation could not be performed.

### (5) Shelf (sedimentation) stability

Each of the resin compositions obtained in Examples 1 and 2 and Comparative Examples 1 and 3 in an amount of 2 ml was put in a glass bottle (inner diameter of bottle mouth: 7.2 mm, body diameter: 16.5 mm, height: 40 mm), and allowed to stand still at 23°C for 72 hours. The states of the amorphous carbon particles, titanium black, and carbon black were visually checked and evaluated based on the following criteria. No evaluation was performed on the resin composition of Comparative Example 2.
o (Good): No sedimentation was observed.
× (Poor): Sedimentation was observed and a clear layer was observed at the upper part of the glass bottle.

**[Table 1]**

| | Substance name | Maker | Weight ratio |
|---|---|---|---|
| Curable composition | 2-Hydroxyethyl methacrylate (2HEMA) | FUJIFILM Wako Pure Chemical Corporation | 30 |
| | Diallyl phthalate | FUJIFILM Wako Pure Chemical Corporation | 10 |
| | Ditrimethylolpropane tetraacrylate | Shin-Nakamura Chemical Co., Ltd. | 10 |
| | Urethane acrylate (U-4HA) | Shin-Nakamura Chemical Co., Ltd. | 10 |

**[Table 2]**

| | Resin composition | | | | | | | | | |
|---|---|---|---|---|---|---|---|---|---|---|
| | Black particles | | Curable composition | Curing agent | Black particles | | | | Resin composition | |
| | Material | Amount (wt%) | Amount (wt%) | Amount (wt%) | Oil absorption (ml/100 g) | Specific gravity | Average particle size (nm) | Powder resistance Ω·cm | OD value of coating film (per 1 µm) | Shelf (sedimentation) stability |
| Example 1 | Amorphous carbon particles | 45 | 52.4 | 2.6 | 78 | 1.4 | 90 | > 10⁶ | 0.65 | O |
| Example 2 | Amorphous carbon particles | 45 | 52.4 | 2.6 | 110 | 1.7 | 50 | > 10⁶ | 0.95 | O |
| Comparative Example 1 | Titanium black | 45 | 52.4 | 2.6 | 65 | 3.9 | 90 | 4.1 × 10⁻¹ | 0.53 | × |
| Comparative Example 2 | Carbon black | 45 | 52.4 | 2.6 | 800 | 1.9 | 34 | 1.8 × 10⁻² | - | - |
| Comparative Example 3 | Black lead particles | 45 | 52.4 | 2.6 | 50 | 22 | 8000 | 1.5 × 10⁻³ | - | × |

### INDUSTRIAL APPLICABILITY

The present invention can provide a resin composition having a high optical density and capable of providing a high-quality color filter excellent in long-term stability and insulation properties. The present invention can also provide a cured product of the resin composition, a black matrix, a color filter, a liquid crystal display device, an organic electroluminescent display device, and a method for producing the resin composition.

## Claims

1. A resin composition comprising:
amorphous carbon-containing black particles; and
a curable compound,
the black particles having a specific gravity of 1.75 or lower and an oil absorption as set forth in JIS K 5101-13-1 of 30 ml/100 g or higher and 120 ml/100 g or lower.

2. The resin composition according to claim 1,
wherein the black particles have a powder resistance at a load of 16 kN of 5.0 × 10⁻¹ Ω·cm or higher.

3. The resin composition according to claim 1 or 2, having an optical density per 1 µm in thickness of 0.6 or higher.

4. The resin composition according to any one of claims 1 to 3,
wherein the black particles have an average particle size of 5 nm or larger and 300 nm or smaller.

5. The resin composition according to any one of claims 1 to 4,
wherein the amorphous carbon is derived from carbon contained in an oxazine resin.

6. The resin composition according to claim 5,
wherein the oxazine resin is a naphthoxazine resin.

7. A cured product obtained by curing the resin composition according to any one of claims 1 to 6.

8. A black matrix formed from the resin composition according to any one of claims 1 to 6.

9. A color filter comprising:
a substrate; and
the black matrix according to claim 8.

10. A liquid crystal display device comprising the color filter according to claim 9.

11. An organic electroluminescent display device comprising the color filter according to claim 9.

12. A method for producing the resin composition according to any one of claims 1 to 6, the method comprising:
preparing a mixed solution containing formaldehyde, an aliphatic amine, and dihydroxynaphthalene or a mixed solution containing triazine and dihydroxynaphthalene;
reacting the mixed solution to form oxazine resin particles; and
carbonizing the oxazine resin particles by heat treatment to obtain amorphous carbon-containing black particles.
